# EUROPÄISCHE PATENTSCHRIFT

(11) **EP 1 980 142 B1**
(45) Veröffentlichungstag und Bekanntmachung des Hinweises auf die Patenterteilung: **13.05.2009**
(21) Anmeldenummer: 07702781.1
(22) Anmeldetag: 16.01.2007
(51) Int. Cl.: H05K 1/02

(54) **LEITERPLATTE MIT FUNKTIONALEN ELEMENTEN UND SELEKTIV GEFÜLLTEN UND THERMISCH LEITFÄHIGEN DURCHSTEIGELÖCHERN SOWIE HERSTELLVERFAHREN UND ANWENDUNG**
PRINTED CIRCUIT BOARD WITH FUNCTIONAL ELEMENTS AND SELECTIVELY FILLED PASSAGE OPENINGS OF GOOD THERMAL CONDUCTIVITY AND METHOD OF PRODUCTION AND USE
CARTE DE CIRCUITS IMPRIMÉS COMPORTANT DES ÉLÉMENTS FONCTIONNELS AINSI QUE DES TROUS D'INTERCONNEXION THERMOCONDUCTEURS REMPLIS DE MANIÈRE SÉLECTIVE, ET PROCÉDÉ DE PRODUCTION ET UTILISATION DE CETTE CARTE DE CIRCUITS IMPRIMÉS

(30) Priorität: 31.01.2006 DE 102006004320
(43) Veröffentlichungstag der Anmeldung: 15.10.2008
(73) Patentinhaber: Häusermann GmbH, 3571 Gars am Kamp (AT)
(72) Erfinder: JANESCH, Rudolf, A-3571 Gars am Kamp (AT); STRUMMER, Erich, A-3571 Gars am Kamp (AT); HACKL, Johann, A-3571 Gars am Kamp (AT)
(74) Vertreter: Riebling, Peter
(86) Internationale Anmeldenummer: PCT/EP2007/000317
(87) Internationale Veröffentlichungsnummer: WO 2007/087980

(56) Entgegenhaltungen:
- JP-A- 9 283 700
- US-A- 3 398 232
- US-A- 5 341 979
- US-A- 6 156 980
- US-A1- 2003 111 742
- US-A1- 2005 146 854

## Beschreibung

Gegenstand der Erfindung ist eine Leiterplatte mit zusätzlichen funktionalen Elementen, insbesondere von rechteckförmigen thermisch gut leitfähigen Elementen, die auf einer oder beiden Oberflächen oder in einer inneren Lage einer Leiterplatte angeordnet und wärmeleittechnisch mittels selektiv thermisch gut leitfähiger, gefüllter Durchsteigelöcher auf die Rückseite geführt sind.

Übliche Leiterplatten werden mittels Ätztechnik, also mittels einer Subtraktivtechnik, hergestellt. Dabei begrenzt im Wesentlichen die jeweils verwendete Kupferfolienstärke von typisch 35 µm oder der halben beziehungsweise der doppelten Dicke und die Strukturbreite die Strombelastbarkeit der Leiterbahnen als auch deren thermisches Ableitvermögen.

In der EP01004226B1 wird ein Verfahren zur Herstellung von drahtgeschriebenen Leiterplatten durch partielles Einfüllen einer härtbaren Isoliermasse in eine oben offene Gießform genannt, was in der vorliegenden Erfindung in keiner Weise vonnöten ist.

In der WO02067642A1 wird ein Verfahren zur Herstellung einer Multiwire-Leiterplatte genannt, bei dem auf einer Seite eines dünnen Flächenelementes aus elektrisch leitendem Material mittels voneinander beabstandeter Klebeflächen Leitungsdrähte definiert verlegt und an vorgegebenen Kontaktstellen des Flächenelementes elektrisch mittels Schweißen, Bonden, Löten, Leitkleben o.dgl. kontaktiert sind.

Auf den fixierten Leitungsdrähten ist ein mechanisches Stabilisierungselement in Form eines Prepregs vorgesehen oder in Form eines mittels Isolierfolie aufgebrachten, elektrisch leitenden oder isolierenden Flächenelementes ausgebildet.
Das Flächenelement ist dabei von der anderen Seite derart strukturiert, dass die Kontaktstellen vom übrigen Flächenelement getrennt sind. In dieser WO02067642A1 werden demzufolge Leitungsdrähte mittels Klebeflächen definiert verlegt, was in der vorliegenden Erfindung nicht erforderlich ist, da die Fixierung mittels Reibschweißen beziehungsweise Ultraschall flächig erfolgt.

Mit der Druckschrift US 5,341,979 A wird ein Verfahren und Mittel zur Verbindung eines Halbleiter-Substrates mit einem Auflagesubstrat offenbart, wobei das als Formstück ausgebildete Halbleiter-Substrat Verbindungsauflagen auf einer ersten Hauptoberfläche und das Auflagesubstrat Kontaktauflagen auf einer Grundoberfläche aufweist und wobei Sanduhrförmig vergoldete Erhebungen auf den Verbindungsauflage gebildet sind. Auf einer weiteren Hauptoberfläche der Formstücke ist ein thermosonorisches Hilfsmittel/ Endeffektor angeordnet und das Auflagesubstrat ist auf einer Substratklemme angeordnet, wobei die Sanduhrförmig vergoldeten Erhebungen zwischen dem Auflagesubstrat und den Erhebungen auf den Kontaktauflagen eine thermosonorische Verbindung ausbilden.
Dieser Druckschrift ist das Merkmal einer Verbindung von zwei Elementen, welche durch ein Durchsteigeloch miteinander verbunden sind, nicht zu entnehmen. Leiterplatten mit zusätzlichen funktionellen Elementen sind auch aus US 2005/146854, US 6,156,980A, US 3,398,232A und JP 09 283 700 bekannt.

Aufgabe der Erfindung ist die kostengünstig Herstellung von multifunktionellen Leiterplatten zur Verdrahtung von komplexen Leiterstrukturen und der Ermöglichung der Montage von Bauteilen mit einer gegenüber dem Stand der Technik verbesserten Wärmeableitung über Durchsteigelöcher.

Dieses Ziel wird durch die kennzeichnenden Merkmalskombinationen des Patentanspruches 1 und 6 erreicht.

Bei der Erfindung sind lediglich selektiv flächige, wärmeableitende Elemente auf oder in Leiterplatten angeordnet und diese werden mittels Durchsteigelöcher auf die Bestückurigsrückseite verbunden und auf diese Weise leiten die Durchsteigelöcher aufgrund deren Füllung mit thermisch gut leitfähigen Materialien die Bauteilwärme auf die Bestückungsrückseite.

Dadurch ergibt sich die Möglichkeit der Integration von thermisch gut leitfähigen, flächigen Elementen, auf die Bauteile montiert werden können, deren Wärmeentwicklung über die Durchsteigelöcher auf die Bestückungsrückseite geführt ist. Dadurch ist eine effiziente Wärmeableitung und Kühlung der montierten Bauteile möglich.

Im Prinzip handelt es sich bei dem vorgenannten, funktionellen Element um eine Wärmeableitfläche oder einen Wärmekollektor, der in der Lage ist, an dieser Stelle entstehende Wärme durch thermisch damit gut leitfähig verbundene Durchsteigelöcher an eine andere Stelle im Leiterplattenverbund abzuleiten.

In einer ersten Ausgestaltung der Erfindung ist es hierbei vorgesehen, dass das funktionelle Element als relativ dicke Metallplatte durch Reibschweißen auf der Kupferoberfläche der Leiterplatte verbunden wird. Der Vorgang des Reibschweißens hat den Vorteil, dass man sehr große, wärmeleitfähige Verbindungsabschnitte zwischen dem relativ dünnen Kupfermaterial auf der Leiterplatte und dem dicken Kupfermaterial oder Metallmaterial des funktionellen Element herstellen kann.

Es ist hierbei nicht notwendig, diese Verbindungsabschnitte elektrisch leitfähig zu gestalten. Es ist zwar in einer ersten Ausführungsform auch eine elektrische Leitfähigkeit vorgesehen. In einer zweiten Ausführungsform kann jedoch auf die elektrische Leitfähigkeit verzichtet werden und nur auf die thermische Leitfähigkeit Wert gelegt werden.

Vorteil der Anbringung eines derartigen funktionellen Elements in Form einer Wärmeableitfläche, die durch ein Reibschweißen oder Ultraschallschweißen auf der Kupferoberfläche der Leiterbahn festgelegt wird, ist, dass man jederzeit nachträglich eine solche Wärmeableitfläche befestigen kann und dass man an den bestimmten Stellen, wo sich die Wärmeabteilung als notwendig erweist, eine solche Wärmeableitfläche anbringen kann.

Weiterer Vorteil der erfindungsgemäßen Maßnahme ist, dass man ein solches funktionelles Element auch im Innenaufbau einer mehrschichtigen Leiterplatte anordnen kann und vom Innenaufbau dieses funktionellen Elements ausgehend dort die Wärme über entsprechend daran ansetzende Durchsteigelöcher zu anderen Stellen der Leiterplatte transportieren kann.

Durch die Kombination einer herkömmlichen, ätztechnisch strukturierten Verdrahtungsebene in Form einer Multilayerleiterplatte mit zusätzlichen funktionalen flächigen Elementen mit entsprechendem Wärmeleitvermögen und der Ausbildung spezieller Durchsteigelöcher, die eine Wärmeableitung auf die Bestückungsrückseite ermöglichen, können kostengünstig Leiterplatten hergestellt werden, die für Bauteile mit hoher Verlustleistung, wie LED's, Mikroprozessoren (CPU's), Thyristoren, Gleichrichter und dergleichen Bauelemente, hervorragend geeignet sind.

In einer ersten Ausführungsvariante werden thermisch gut leitfähige flächige Elemente mittels Reibschweißverfahren beziehungsweise Ultraschallschweißverfahren flächig auf eine ätztechnisch hergestellte Leiterstruktur oder auch auf einer noch nicht strukturierten Kupferfolie befestigt und anschließend mittels entsprechender Harzsysteme beziehungsweise mittels Laminationsprozess einebnend bearbeitet.

In einer Weiterbildung dieser Ausführung werden flache, wärmeableitende Elemente auf beiden Oberflächen oder auch in inneren Lagen angeordnet und mittels Durchsteigelöchern verbunden und die Durchsteigelöcher werden mittels thermisch gut leitenden Füllstoffen gefüllt.

Die Erfindung bezieht sich demnach auf eine Leiterplatte mit zusätzlichen funktionalen Elementen und Durchsteigelöchern, die selektiv mit thermisch gut leitfähigen Materialien gefüllt sind und so die Prozesswärme eines Bauteils auf die Rückseite ableiten können. Dabei können hochkomplexe feine Strukturen eines mehrlagigen Schaltungsträgers mit der Möglichkeit der Integration von funktionalen Elementen erzielt werden, wobei die flächigen funktionalen Elemente mit einem Bauteil versehen sind und die Durchsteigelöcher mit guter Wärmeleiteigenschaft die Prozesswärme auf die Rückseite des Schaltungsträgers führen.

Als Material für die funktionalen Elemente werden bevorzugt Kupfer oder Aluminium verwendet und die Elemente können in der gewünschten geometrischen Abmessung bereits fertig vorliegen oder sie können von Rolle zugeführt werden und beim Applikationsprozess mittels einer entsprechend gestalteten Sonotrode abgelängt oder sie können nach der Applikation noch nachbearbeitet werden.

Die Durchsteigelöcher werden bevorzugt mittels mechanischer Bohrer oder mittels Laser hergestellt. Sie können jedoch ebenso mittels Stanzen hergestellt werden. Die Ausbildung der Durchsteigelöcher für eine thermisch gute Leitfähigkeit kann mittels galvanischer Durchkontaktierungsverfahren erfolgen oder bevorzugt mittels Befüllmethoden, wie dem selektiven Füllen mittels Dispensersystemen oder mittels Siebdruck. Speziell mittels Dispenser sind selektiv sehr Material- und Kosten- schonende Befüllverfahren möglich und es können thermisch gut leitfähige Pasten verwendet werden. Derartige Pasten können überdies elektrisch leitfähig oder elektrisch ableitend oder elektrisch isolierend ausgebildet sein. Weiters können derartige Pasten lösbar oder aushärtend ausgebildet sein.

Die Befüllung der thermisch gut leitfähigen Durchsteigelöcher kann auch kurz vor der Applikation des Bauteils beziehungsweise des Kühlkörpers erfolgen. Dabei kann ein gewisser Pastenüberschuß aufgetragen werden, der die kompletten Kontaktflächen im assemblierten Zustand bedeckt.

Alle in den Unterlagen, einschließlich der Zusammenfassung offenbarten Angaben und Merkmale, insbesondere die in den Zeichnungen dargestellte Ausbildung, werden als erfindungswesentlich beansprucht, soweit sie einzeln oder in Kombination gegenüber dem Stand der Technik neu sind.

Die Erfindung wird nun anhand mehrerer Ausführungsbeispiele näher beschrieben. Hierbei gehen aus den Zeichnungen und ihrer Beschreibung weitere Vorteile und Merkmale hervor.

Einige Ausführungsbeispiele der Erfindung werden nachfolgend anhand der Zeichnungsfiguren näher beschrieben.

Dabei zeigen:
**Figur 1**:eine schematische Darstellung einer multifunktionellen Leiterplatte (1) mit einem funktionellen Element (3) in einer einfachen Ausführungsform im Schnitt,
**Figur 2**:eine schematische Darstellung einer multifunktionellen Leiterplatte (1) mit einem funktionellen Element (3) in einer Innenlage im Schnitt,
**Figur 3**:eine schematische Darstellung einer erfindungsgemäßen multifunktionellen Leiterplatte (1) mit einem funktionellen Elementen (3) und darauf montiertem Bauteil (16) und Durchsteigelöchern (20) im Schnitt.
**Figur 4**: eine schematische Darstellung einer multifunktionellen Leiterplatte (1) mit einem funktionellen Element (3) in einer Innenlage in der Ansicht von unten.

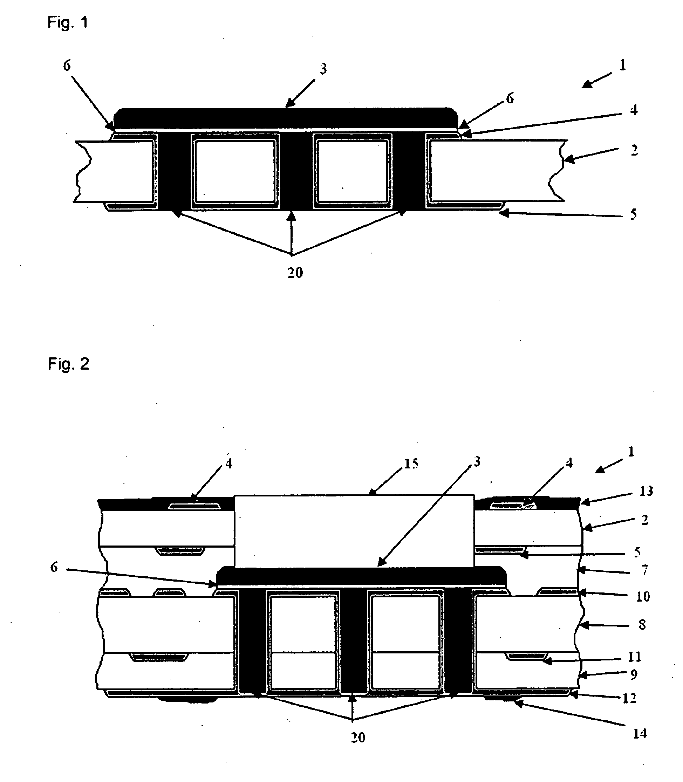

In **Figur 1** wird eine schematische Darstellung einer multifunktionellen Leiterplatte (1) mit einem funktionellen Element (3) in einer einfachen Ausführungsform im Schnitt aufgezeigt.

In dieser einfachen Ausführungsform wird ein Substrat (2) aus einem üblichen Leiterplattenmaterial wie FR-2, FR-3, FR-4, FR-4-Low-Tg, CEM-1, CEM-x, PI, CE, Aramid und dergleichen Substratmaterialien mit beidseitig hergestellter Leiterbahnstruktur (4, 5) verwendet und es wird ein funktionelles Element (3) flächig mittels Ultraschall beziehungsweise einem Reibschweißvorgang auf die zumindest zwei gezeichneten Leiterbahnstrukturen (4) kontaktiert.

In einer ersten Ausführungsform kann dabei das funktionelle Element (3) aus Kupfer oder Aluminium verwendet werden und dabei wird üblicherweise mit der aus Kupfer bestehende Leiterbahnstruktur (4) eine intermetallische Verbindung hergestellt.

In weiteren Ausbildungen der vorliegenden Erfindung können die Oberflächen der Kontaktpaare chemisch oder galvanisch oder mittels Heißverzinnung (HAL) beschichtet sein.

Bei entsprechender Materialpaarung wird in einem üblichen Frequenzbereich von einigen kHz bis über 30 kHz Ultraschallenergie und bei entsprechender Sonotrodenausbildung und bei entsprechendem Anpressdruck eine flächige intermetallische Verbindung hergestellt, wobei lediglich in einem wenige µm-Tiefe umfassenden Kontaktbereich eine für die Ausbildung des intermetallischen Kontaktes erforderliche hohe Temperatur erreicht wird.

Damit erfährt das gesamte System örtlich keine große Erwärmung und es treten gegenüber Punktschweiß-Verbindungen nahezu keine Thermospannungen auf, sodass die Verbindungspartner auch nach dem Verbindungsvorgang eine plane Lage aufweisen.

Bei Verwendung von lackisolierten, funktionellen Elementen (3) kann bei spezieller Ausbildung der Kontaktpartner und bei entsprechender Ausbildung der Lackschicht eine intermetallische Kontaktschicht (6) erreicht werden. Es können jedoch auch die Kontaktflächen mechanisch und/oder chemisch von einer allfälligen Isolationsschicht befreit werden. Dabei können Schleifverfahren, Bürstverfahren, Fräsverfahren oder ein Ätzverfahren oder ein Plasmaverfahren oder ein UV-Laserverfahren verwendet werden.

In einer weiteren Ausbildung der vorliegenden Erfindung kann das funktionelle Element (3) als Stückelement mit der gewünschten geometrischen Abmessung verwendet werden oder es kann von einer Rolle zugeführt und gegebenenfalls durch eine geeignete Ausbildung der Sonotrode beim Kontaktiervorgang abgelängt werden.

Wahlweise kann im Anschluß an den Kontaktier- und Verlegevorgang noch ein Kalandriervorgang in Form von Kalander-Rollen oder einer Flachpressvorgang ausgeführt werden, sodass die Planlage bei kritischen Produkten erhöht wird.

In diesem Ausführungsbeispiel ist das Element (3) mit der intermetallischen Verbindung (6) zu der Leiterbahnstruktur (4) durch drei Durchsteigelöcher (20) mit der unteren Leiterbahnstruktur (5) thermisch gut leitend verbunden. Die Durchsteigelöcher (20) werden mittels Bohren oder mit Laserablation hergestellt und es können dabei entsprechend große Bohrungen ausgebildet werden, die anschließend mit thermisch gut leitfähigen Materialien befüllt werden.

Der Füllvorgang kann dabei selektiv mittels Dispenserdüsen-Robotersystemen oder auch mittels entsprechender Siebdrucksysteme erfolgen. Es kann jedoch ebenso ein galvanischer Abscheideprozess verwendet werden oder eine entsprechend angepasste Heißluftverzinnung. In allen Fällen muss darauf geachtet werden, dass die Durchsteigelöcher (20) thermisch gut leitend befüllt sind.

In **Figur 2** ist eine schematische Darstellung einer multifunktionellen Leiterplatte (1) mit einem funktionellen Element (3) in einer Innenlage (7) im Schnitt aufgezeigt. Das Substrat (7) wird für die Einbettung beim Laminiervorgang verwendet, sodass eine weitgehend gleich dicke und ebene Leiterplatte (1) erreicht wird.

In dieser Figur 2 ist lediglich ein funktionelles Element (3) über einem Element einer Verdrahtungsstruktur (10) mit der intermetallischen Verbindungsschicht (6) dargestellt. Das funktionelle Element (3) kann grundsätzlich auch Leiterbahnstrukturen überkreuzen und es können Elemente (3) auch in den Substratebenen (2, 8, 9) beziehungsweise auf den Leiterbahnstrukturen (4, 5, 10, 11, 12) angeordnet werden.

Die Kontaktierung derartiger funktionaler Elemente (3) erfolgt über die intermetallische Verbindung (6) und einer darunter befindlichen Leiterbahnstruktur (10) über Durchsteigelöcher (20) beziehungsweise Sacklöcher auf eine Kontaktfläche (12).

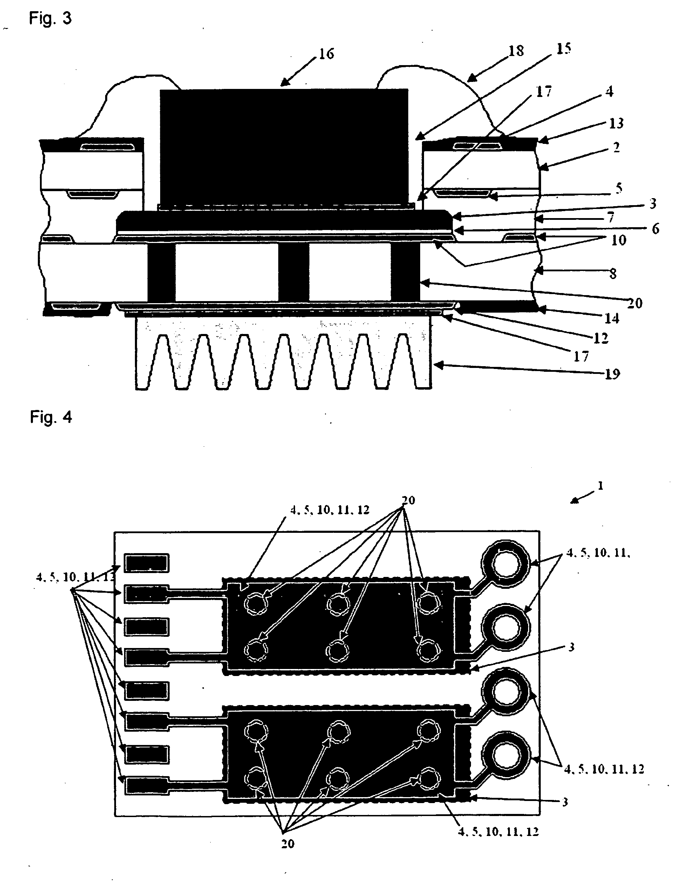

In **Figur 3** ist eine schematische Darstellung einer erfindungsgemäßen multifunktionellen Leiterplatte (1) mit einem funktionellen Elementen (3) und darauf montiertem Bauteil (16) und Durchsteigelöchern (20) im Schnitt gezeigt.

In dieser Ausführurigsform ist das funktionelle Element (3) im Inneren der Leiterplatte (1) angeordnet und die obere Oberfläche wird zumindest stückweise durch eine Kavität (15) freigelegt. Auf diese zumindest stückweise freigelegte Oberfläche des Elementes (3) wird mit einer thermischen Kontaktierung (17) ein Bauteil (16) befestigt. Die thermische Kontaktierung (17) kann dabei lösbar oder unlösbar ausgeführt werden und sie kann elektrisch leitend oder nicht-leitend ausgebildet werden.

Die zumindest stückweise durch die Kavität (15) freigelegte Oberfläche des Elementes (3) kann zusätzlich chemisch beziehungsweise galvanisch mit einer oder mit mehreren Schichten versehen oder mittels Heißluftverzinnung oder mit Pasten bedeckt sein.

Falls eine elektrisch und thermisch leitfähige Verbindung gewünscht wird, muss auf die rasche Passivierung beziehungsweise Oxidation von Kupferbeziehungsweise Aluminium-Oberflächen geachtet werden und die Kontaktierungsschicht (17) muss darauf abgestimmt sein.

Die Ausbildung einer Kavität (15) ist nur beispielhaft genannt. Sie kann auch von unten erfolgen oder von beiden Seiten oder sie kann entfallen. Das entsprechende funktionale Element (3) wird bevorzugt als Kontaktierbasis für das Bauteil (16) verwendet. Es kann jedoch zusätzlich auch ein funktionales Element (3) im Bereich eines allfällig zu montierenden Kühlkörpers (20) angeordnet werden.

Die Kavität (15) wird üblicherweise durch einen Fräsprozess oder einen Laserprozess hergestellt, wobei die Oberfläche des Elementes (3) zumindest stückweise für eine gute thermische Ankoppelung freigelegt wird.

Die Vergußmasse (18) ist in Figur 3 schematisch nur berandend eingezeichnet. Sie kann den Bauteil (16) jedoch auch nur im Kontaktbereich oder aber auch komplett bedecken. Dabei kann die Vergußmasse (18) als sogenannter Underfiller sehr dünnflüssig alle Hohlräume ausfüllen und so passivierend und haftverbessernd wirken.

Falls die Vergußmasse (18) den Bauteil komplett bedeckt, wird im Falle der Verwendung von einem optoelektronischen Bauteil (16) auf hohe Transparenz geachtet. Oftmals werden die Vergußmassen (18) auch dunkel beziehungsweise opak und für Licht undurchlässig ausgebildet und es werden darunter befindliche fotosensitive Bauteile geschützt.

Die Lötstoppmasken (13, 14) auf den Strukturen (4, 12 dienen der Maskierung bei Bestückungsprozessen beziehungsweise der Isolation und Passivierung von oberflächigen Leiterbahnstrukturen (4, 12).

Die Durchsteigelöcher (20) werden mittels mechanischer Bohrwerke oder mittels Laseranlagen hergestellt. Sie können jedoch auch grundsätzlich mittels Stanzen hergestellt werden. Die Ausbildung der guten thermischen Leitfähigkeit der Durchsteigelöcher (20) kann galvanisch erfolgen. Es werden dabei übliche elektrisch leitfähige und derart auch thermisch gut leitfähige Metalle oder Metall-Legierungen verwendet. Bevorzugt wird eine komplette Füllung der Durchsteigelöcher (20) angestrebt.

In einem kostengünstigen und selektiven Verfahren können die Durchsteigelöcher (20) auch mittels NC-gesteuerter Dispenser oder mittels spezieller Siebdruckanlagen mit thermisch gut leitfähigen Pasten gefüllt werden. Dabei können die Pasten elektrisch leitfähig als auch isolierend ausgeführt werden. Damit können wesentlich größere Bohrungen gefüllt werden, als beim Stand der Technik in durchkontaktierten Leiterplatten beziehungsweise in Multilayerleiterplatten üblich sind.

Üblicherweise werden die Durchsteigelöcher (20) von der Leiterplattenrückseite angefertigt und auch von dieser Seite mit thermisch gut leitfähigem Material befüllt.

In **Figur 4** ist eine schematische Darstellung einer multifunktionellen Leiterplatte (1) mit zwei funktionellen Elementen (3) in einer Innenlage in der Ansicht von unten gezeigt. In diesem Beispiel sind zwei funktionelle Elemente (3) dargestellt, die jeweils mit 6 Durchsteigelöchern (20) mit der Bauteilgegenseite thermisch gut leitend verbunden sind.

Die entsprechenden Anschlussflächen (4, 5, 10, 11, 12) sind in diesem Beispiel als retativ kleine Kontaktflächen in einem Rastermaß beziehungsweise als Lötring dargestellt. Die Kontakte können jedoch genauso gut wegfallen oder nur mit der Masse (Erdung) verbunden sein.

Üblicherweise werden die Durchsteigelöcher (20) zwischen zwei der Kupferlagen (4, 5, 10, 11, 12) von der Leiterplattenunterseite mittels Bohren oder Laserablation hergestellt und auch von der Bauteilunterseite mit thermisch gut leitfähigen pastösen Materialien befüllt.

### Bezugszeichenliste

- 1: Multifunktionelle Leiterplatte mit zumindest einem funktionalen Element
- 2: Substrat: Basismaterial z.B. FR-2, FR-3, FR-4, FR-4-Low-Tg, CEM-1, CEM-x, PI, CE, Aramid, usw. bzw. Prepreg
- 3: Funktionales Element: rund oder rechteckig bzw. bandförmig; Kupfer oder Aluminium oder elektrisch u/o thermisch gut leitfähig
- 4: Leiterbahnstruktur: z.B. geätztes Kupfer
- 5: Leiterbahnstruktur Unterseite
- 6: Intermetallische Verbindung: US- bzw. Reibschweißen
- 7: Substrat 2: z.B. Innenlage bzw. Kernlage
- 8: Substrat 3: z.B. Innenlage bzw. Kernlage
- 9: Substrat 4: z.B. Außenlage bzw. Prepreg
- 10: Leiterbahnstruktur innenliegend
- 11: Leiterbahnstruktur innenliegend
- 12: Leiterbahnstruktur außenliegend
- 13: Soldermaske bzw. Lötstopmaske oben
- 14: Soldermaske bzw. Lötstopmaske unten
- 15: Kavität oben
- 16: Bauteil
- 17: Thermische Kontaktierung (inkl. mechanischer Befestigung/Montage)
- 18: Vergußmasse
- 19: Kühlkörper
- 20: Durchkontaktierung bzw. Durchsteigeloch

## Patentansprüche

1. Multifunktionelle Leiterplatte (1) mit zumindest einem zusätzlichen funktionellen Element (3), wobei ein oder mehrere funktionelle Elemente (3) zumindest mit der einen Seite eines Durchsteigelochs (20) thermisch gut leitend verbunden ist, dessen andere Seite auf der Bestückungsrückseite thermisch gut leitend mit einem flächigen, thermisch gut leitenden Element (12) verbunden ist, **dadurch gekennzeichnet, dass** das funktionelle Element (3) mittels Ultraschall beziehungsweise mittels Reibschweißen zumindest stückweise flächig auf eine Kupferfolie (4, 5, 10, 12) mit einer intermetallischen Verbindung (6) befestigt ist, wobei zumindest zwei funktionelle Elemente (3) über zumindest ein Durchsteigeloch (20) beziehungsweise mehrere Durchsteigelöcher (20) thermisch gut leitend verbunden sind und auf der einen Seite ein Bauteil (16) und auf der anderen Seite ein Kühlkörper (19) mittels thermischer Kontaktierung (17) angeordnet ist, wobei das Bauteil (16) mittels dem Kühlkörper (19) gekühlt ist.

2. Multifunktionelle Leiterplatte (1) nach Anspruch 1, **dadurch gekennzeichnet, dass** die multifunktionelle Leiterplatte (1) eine durchkontaktierte Leiterplatte ist beziehungsweise eine Multilayerleiterplatte ist.

3. Multifunktionelle Leiterplatte (1) nach einem der Ansprüche 1 bis 2, **dadurch gekennzeichnet, dass** das zumindest eine Durchsteigeloch (20) komplett mit einem thermisch gut leitfähigen Material gefüllt ist.

4. **Verfahren** zur Herstellung einer multifunktionellen Leiterplatte (1) mit zumindest einem zusätzlichen funktionellen Element (3), wobei das zumindest eine funktionelle Element (3) mittels Ultraschall beziehungsweise mittels Reibschweißen in Form einer intermetallischen Verbindung (6) mit einer Kupferfolie (4, 5,10) zumindest stückweise flächig verbunden ist und zumindest mit einem oder mehreren Durchsteigelöchern (20) thermisch gut leitend, sowie mit einem flächigen thermisch gut leitenden Element (12) auf der Bestückungsrückseite verbunden ist, **dadurch gekennzeichnet, dass** zumindest zwei funktionelle Elemente (3) über zumindest ein Durchsteigeloch (20) beziehungsweise mehrere Durchsteigelöcher (20) thermisch gut leitend verbunden werden und auf der einen Seite ein Bauteil (16) und auf der anderen Seite ein Kühlkörper (19) mittels thermischer Kontaktierung (17) anordnungsbar ist, wobei der Kühlkörper (19) das Bauteil (16) kühlt.

5. **Verfahren** zur Herstellung einer multifunktionellen Leiterplatte (1) mit zumindest einem zusätzlichen funktionellen Element (3) nach Anspruch 4, **dadurch gekennzeichnet, dass** zumindest zwei funktionelle Elemente (3) über zumindest ein Durchsteigeloch (20) beziehungsweise mehrere Durchsteigelöcher (20) thermisch gut leitend verbunden sind und auf der einen Seite ein Bauteil (16) und auf der anderen Seite eine Kühlkörper (19) mittels thermischer Kontaktierung (17) angeordnet ist und der Kühlkörper (19) das Bauteil (16) kühlt.

6. **Verfahren** zur Herstellung einer multifunktionellen Leiterplatte (1) mit zumindest einem zusätzlichen funktionellen Element (3) nach Anspruch 4 und 5, **dadurch gekennzeichnet, dass** das zumindest eine Durchsteigeloch (20) beziehungsweise die mehreren Durchsteigelöcher (20) komplett mit einem thermisch gut leitfähigen Material gefüllt sind.

7. **Anwendung** einer multifunktionellen Leiterplatte (1) mit zumindest einem zusätzlichen funktionellen Element (3) nach einem der Ansprüche 1 bis 6 für die Abteilung der Wärme eines Bauteils, insbesondere von LED-Bauteilen und CPU-Bauteilen und Leistungsbauteilen wie Thyristoren und Gleichrichter und dergleichen-Wärme entwickelnde Bauteile, von einer Seite einer Leiterplatte (1) auf die andere Seite einer Leiterplatte mittels thermisch gut leitfähig komplett gefüllter Durchsteigelöcher.

## Claims

1. Multifunctional printed circuit board (1) comprising at least one additional functional element (3), one or more functional elements (3) being connected with good thermal conductivity at least to one side of a passage opening (20), the other side of which, on the rear component side, being connected with good thermal conductivity to a flat element (12) that has good thermal conductivity, **characterised in that** the functional element (3) is fastened, at least in portions, in a planar manner onto a copper foil (4, 5, 10, 12) with an inter-metallic connection (6), by means of ultrasound or by means of friction welding, at least two functional elements (3) being connected with good thermal conductivity by means of at least one passage opening (20) or a plurality of passage openings (20), and a component (16) being arranged on one side and a heat sink (19) being arranged on the other side by means of thermal contacting (17), the component (16) being cooled by means of the heat sink (19).

2. Multifunctional printed circuit board (1) according to claim 1, **characterised in that** the multifunctional printed circuit board (1) is a through-contacted printed circuit board, or a multi-layer printed circuit board.

3. Multifunctional printed circuit board (1) according to either of claims 1 or 2, **characterised in that** at least one passage opening (20) is completely filled with a material that has good thermal conductivity.

4. Method for producing a multifunctional printed circuit board (1) with at least one additional functional element (3), the at least one functional element (3) being connected at least in portions in a planar manner by means of ultrasound or by means of friction welding in the form of an inter-metallic connection (6) to a copper foil (4, 5, 10), and being connected with good thermal conductivity to at least one or more passage openings (20) and to a planar element (12) that has good thermal conductivity on the rear component side, **characterised in that** at least two functional elements (3) are connected with good thermal conductivity by means of at least one passage opening (20) or a plurality of passage openings (20) and a component (16) can be arranged on one side and a heat sink (19) can be arranged on the other side by means of thermal contacting (17), the heat sink (19) cooling the component (16).

5. Method for producing a multifunctional printed circuit board (1) with at least one additional functional element (3) according to claim 4, **characterised in that** at least two functional elements (3) are connected with good thermal conductivity by means of at least one passage opening (20) or a plurality of passage openings (20) and a component (16) is arranged on one side and a heat sink (19) is arranged on the other side by means of thermal contacting (17) and the heat sink (19) cools the component.

6. Method for producing a multifunctional printed circuit board (1) with at least one additional functional element (3) according to claim 4 and 5, **characterised in that** the at least one passage opening (20) or the plurality of passage openings (20) are completely filled with a material having good thermal conductivity.

7. Application of a multifunctional printed circuit board (1) with at least one additional functional element (3) according to any one of claims 1 to 6 for dissipating the heat of a component, in particular of LED components and CPU components and power components such as thyristors and rectifiers and similar components developing heat, from one side of a printed circuit board (1) to the other side of a printed circuit board by means of completely filled passage openings with good thermal conductivity.

## Revendications

1. Carte de circuits imprimés multifonctionnelle (1) avec au moins un élément fonctionnel supplémentaire (3), étant précisé qu'un ou plusieurs éléments fonctionnels (3) sont reliés avec une bonne conductibilité thermique au moins à un premier côté d'un trou traversant (20) dont l'autre côté, sur la face arrière de garnissage, est relié avec une bonne conductibilité thermique à un élément plat (12) à bonne conductibilité thermique,
**caractérisée en ce que** l'élément fonctionnel (3) est fixé par ultrasons ou par soudage par friction, à plat au moins par endroits, sur une feuille de cuivre (4, 5, 10, 12) avec une liaison intermétallique (6), étant précisé qu'au moins deux éléments fonctionnels (3) sont reliés avec une bonne conductibilité thermique par l'intermédiaire d'un au moins un trou traversant (20) ou de plusieurs trous traversants (20), et qu'il est prévu sur un côté un composant (16) et sur l'autre côté un organe de refroidissement (19), à l'aide d'une connexion thermique (17), le composant (16) étant refroidi à l'aide de l'organe de refroidissement (19).

2. Carte de circuits imprimés multifonctionnelle (1) selon la revendication 1, **caractérisée en ce qu'**elle est constituée par une carte de circuits imprimés métallisée ou par une carte de circuits imprimés multicouche.

3. Carte de circuits imprimés multifonctionnelle (1) selon l'une des revendications 1 à 2, **caractérisée en ce que** le ou les trous traversants (20) sont complètement remplis d'une matière bonne conductrice de chaleur.

4. Procédé pour fabriquer une carte de circuits imprimés multifonctionnelle (1) avec au moins un élément fonctionnel supplémentaire (3), étant précisé que ledit élément fonctionnel (3) est relié par ultrasons ou par soudage par friction, à plat au moins par endroits, sous la forme d'une liaison intermétallique (6), à une feuille de cuivre (4, 5, 10), et est relié avec une bonne conductibilité thermique à au moins un ou plusieurs trous traversants (20) et, côté garnissage, à un élément plat (12) bon conducteur de chaleur,
**caractérisé en ce qu'**au moins deux éléments fonctionnels (3) sont reliés avec une bonne conductibilité thermique par l'intermédiaire d'au moins un trou traversant (20) ou de plusieurs trous traversants (20), et qu'il peut être prévu sur un côté un composant (16) et sur l'autre côté un organe de refroidissement (19) à l'aide d'une connexion thermique (17), l'organe de refroidissement (19) refroidissant le composant (16).

5. Procédé pour fabriquer une carte de circuits imprimés multifonctionnelle (1) avec au moins un élément fonctionnel supplémentaire (3) selon la revendication 4, **caractérisé en ce qu'**au moins deux éléments fonctionnels (3) sont reliés avec une bonne conductibilité thermique par l'intermédiaire d'au moins un trou traversant (20) ou de plusieurs trous traversants (20), et qu'il peut être prévu sur un côté un composant (16) et sur l'autre côté un organe de refroidissement (19) à l'aide d'une connexion thermique (17), et que l'organe de refroidissement (19) refroidit le composant (16).

6. Procédé pour fabriquer une carte de circuits imprimés multifonctionnelle (1) avec au moins un élément fonctionnel supplémentaire (3) selon les revendications 4 et 5, **caractérisé en ce que** ledit trou traversant (20) ou le ou les trous traversants (20) sont complètement remplis d'une matière bonne conductrice de chaleur.

7. Application d'une carte de circuits imprimés multifonctionnelle (1) avec au moins un élément fonctionnel supplémentaire (3) selon l'une des revendications 1 à 6 pour l'évacuation de la chaleur d'un composant, en particulier de composants de diodes lumineuses et de composants d'unités centrales et de composants de puissance tels que des thyristors et de redresseurs et de composants similaires dégageant de la chaleur, d'un côté à l'autre d'une carte de circuits imprimés (1), à l'aide de trous traversants qui sont complètement remplis d'une matière bonne conductrice de chaleur.
